Europäisches Patentamt

European Patent Office

Office européen des brevets

(11) Numéro de publication: **0 346 166**
**A1**

(12) **DEMANDE DE BREVET EUROPEEN**

(21) Numéro de dépôt: **89401281.4**

(22) Date de dépôt: **09.05.89**

(51) Int. Cl.⁴: **H 01 L 23/46**
**H 01 L 21/00, G 01 R 31/28**

(30) Priorité: **10.05.88 FR 8806293**

(43) Date de publication de la demande:
**13.12.89 Bulletin 89/50**

(84) Etats contractants désignés: **DE GB IT**

(71) Demandeur: **SOCIETE D'APPLICATIONS GENERALES
D'ELECTRICITE ET DE MECANIQUE SAGEM
6, Avenue d'Iéna
F-75783 Paris Cédex 16 (FR)**

(72) Inventeur: **Galian, François
83, Avenue du Château
F-77340 Pontault-Combault (FR)**

**Feuillioux, André
38, Rue Christophe Thivrier
F-03000 Montlucon (FR)**

(74) Mandataire: **Gorree, Jean-Michel et al
Cabinet Plasseraud 84, rue d'Amsterdam
F-75009 Paris (FR)**

Le titre de l'invention a été modifié (Directives relatives à l'examen pratiqué à l'OEB, A-III, 7.3)

(54) **Dispositif permettant d'ajuster la température d'un élément par soufflage d'un gaz à la température appropriée.**

(57) Dispositif de réglage thermique pour ajuster à une valeur souhaitée la temperature d'un élément (7) par soufflage sur celui-ci d'un gaz à la temperature souhaitée, comportant : un corps (1) renfermant un conduit (2) d'amenée du gaz ; une cloche d'isolement (6) montée à coulissement sur l'extrémité (3) du conduit pour entourer l'élément (7) ; un soufflet (15) entre la cloche (6) et le corps (1) ; un tube (19) enfermé dans le corps (1) pour évacuer le gaz hors de la cloche ; la cloche et le soufflet étant en un matériau thermiquement isolant.

FIG.2.

EP 0 346 166 A1

## Description

**Perfectionnements apportés aux dispositifs permettant d'ajuster la température d'un élément par soufflage d'un gaz à la température appropriée.**

La présente invention concerne des perfectionnements apportés aux dispositifs de réglage thermique utilisés pour ajuster à une valeur souhaitée (positive ou négative) la température d'un élément, notamment d'un composant semi-conducteur en cours de test électrique dans des conditions thermiques variables (par exemple entre -65 et 210°C), cet ajustement de température étant obtenu par soufflage, sur l'élément, d'un gaz à la température souhaitée, ce dispositif de règlage thermique comportant un corps supportant un conduit d amenée du gaz à la température appropriée et des moyens d'isolement de l'élément vis-à-vis de l'atmosphère ambiante, ces moyens d'isolement comprenant une cloche d'isolement agencée pour coiffer l'élément et supportée à coulissement par l'extrémité libre du conduit précité, des moyens élastiques étant interposés entre la cloche d'isolement et le corps du dispositif pour maintenir cette cloche en appui élastique étanche contre le support de l'élément avec lequel elle coopère.

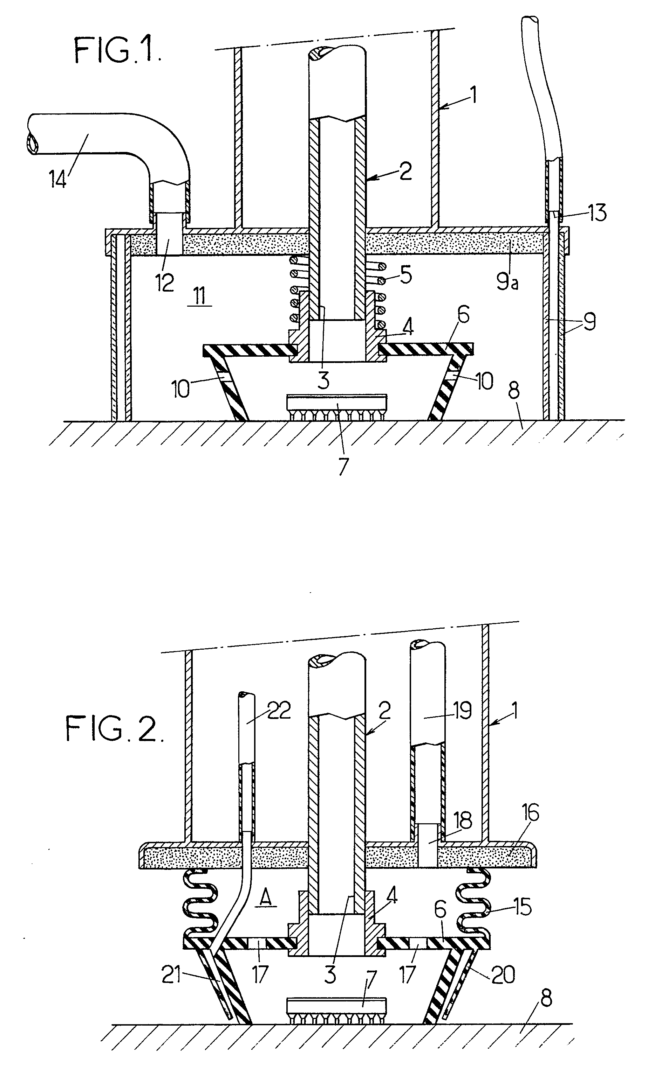

La figure 1 du dessin annexé représente schématiquement, en coupe transversale, un agencement d'un dispositif conforme à l'état de la technique. Le corps 1 du dispositif (qui est simplement suggéré sur le dessin et dont l'équipement intérieur n'a pas été représenté) -qui peut être suspendu par exemple à une potence facilitant sa mise en place et son retrait- contient un conduit 2 amenant le gaz de réglage thermique (à une température positive ou négative) fourni par une source (non représentée). L'extrémité inférieure 3 du conduit 2 est entourée d'un manchon coulissant 4 repoussé élastiquement vers le bas par un ressort en hélice 5 entourant l'extrémité inférieure du conduit 2. Le manchon 4 supporte une cloche 6, par exemple en caoutchouc, qui est dimensionnée et configurée pour pouvoir coiffer un élément 7, par exemple un circuit intégré en cours de test électrique dans des conditions thermiques variables. Le bord inférieur de la cloche 6 est maintenu en appui élastique étanche, par le ressort 5, contre la surface du support 8 du composant 7 (sur le dessin, le support 8 est représenté avec l'élément 7, seul, le connecteur électrique assurant la retenue mécanique du composant et les liaisons électriques avec le circuit de test n'étant pas montré pour simplifier la représentation).

En outre, solidaire de la partie inférieure du corps 1 se trouve une enceinte 11 de récupération des gaz qui entoure la cloche 6 et qui est délimitée par un plafond isolant 9a traversé par le conduit 2 et par des parois latérales 9 constituées par une double cloison en verre.

Le gaz de réglage de température est amené dans la cloche 6 par le conduit 2 dont l'extrémité inférieure 3 débouche au-dessus de l'élément 7, s'échappe par des orifices 10 percés dans les parois latérales de celle-ci, puis est enfin évacué de l'enceinte 11 par un orifice d'évacuation 12 prévu dans le plafond 9a. Une amenée d'air sec est effectuée par un orifice 13, débouchant entre les deux parois de verre de la double paroi 9 afin d'éviter la condensation de l'humidité de l'atmosphère ambiante et son givrage lors d'essais sous basses températures.

Cet agencement connu présente de nombreux inconvénients.

Tout d'abord, cette structure est, dans son ensemble, lourde, encombrante et complexe, et donc coûteuse à l'achat et peu pratique d'utilisation. De plus la présence de la double paroi 9 en verre limite le débattement vertical de la cloche 6. En outre, pour éviter le rejet des gaz dans l'atmosphère directement à la sortie de l'orifice 12 et la formation de condensation susceptible de givrer, lors d'essais sous basses températures, à proximité immédiate du dispositif, et pour éviter aussi que le gaz soit évacué à hauteur du visage de l'opérateur contrôlant le fonctionnement de l'appareil, il est prévu de fixer sur l'orifice 12 un tube d'évacuation 14 suffisamment long et conformé pour que les gaz soient évacués au loin ; toutefois, ce tube 14 est encombrant et gêne les manipulations du dispositif.

Divers essais ont été faits pour tenter de simplifier cette structure connue, mais aucun jusqu'à présent n'a donné satisfaction.

L'invention a donc essentiellement pour but de remédier aux inconvénients ci-dessus exposés, et de proposer un agencement perfectionné d'un dispositif de réglage thermique du type défini plus haut qui soit d'une tructure plus simple, moins encombrante et moins coûteuse que les dispositifs actuellement connus et qui soit aussi d'une conception plus pratique en cours d'utilisation et qui procure moins de gêne à l'opérateur.

A ces fins, un dispositif de réglage thermique agencé conformément à l'invention se caractérise essentiellement par la combinaison des dispositions qui suivent :
- entre la cloche d'isolement et le corps est interposé un soufflet tubulaire sensiblement coaxial au conduit d'amenée de gaz et définissant, avec les parois en regard de la cloche d'isolement, du corps et du conduit, une chambre annulaire, ledit soufflet étant en outre agencé pour jouer le rôle des susdits moyens élastiques maintenant la cloche en appui élastique étanche contre la surface du support de l'élément ;
- la cloche et le soufflet sont constitués tout deux en un matériau ou en des matériaux respectifs très bons isolants thermiques ;
- la cloche est munie d'au moins un passage établissant une communication entre son volume intérieur et ladite chambre annulaire ;
- le corps du dispositif est traversé sur toute sa hauteur par un tube d'évacuation s'ouvrant dans la chambre annulaire à son extrémité inférieure et débouchant dans l'atmosphère à son extrémité supérieure.

Grâce à cet agencement, on obtient une structure beaucoup plus compacte et beaucoup moins fragile que les structures antérieures du fait de la disparition pure et simple des parois en verre utilisées jusqu'alors ; le débattement vertical de la cloche peut s'effectuer avec une grande amplitude si souhaité, du fait de la suppression des butées verticales que constituaient ces mêmes parois en verre ; du fait que le tube d évacuation est intégré dans le corps même du dispositif et débouche à la partie supérieure de celui-ci, l'environnement de la tête n'est plus encombré par ce tube, ce qui laisse plus de liberté de manoeuvre à l'opérateur, et le dégagement des gaz s'effectue à une hauteur suffisante et dans une direction (vers le haut en principe) qui n'apporte, là encore, aucune gêne. Le recours à un matériau très bon isolant thermique (tel qu'un caoutchouc siliconé par exemple) pour constituer la cloche et le soufflet permet d'être assuré de l'absence de givrage sur leurs surfaces externes respectives lors d'essais sous très basses températures.

Dans un mode de réalisation préféré, le soufflet possède une paroi relativement épaisse (qui en tout état de cause serait trop mince pour procurer l'isolement thermique nécessaire) et, en position de fonctionnement, le soufflet est écrasé sur lui-même, à spires jointives, ce qui réalise une paroi effective épaisse et thermiquement isolante apte à empêcher le givrage sur sa surface externe lors d'essais sous basses températures.

De façon très avantageuse, la cloche d'isolement et le soufflet sont constitués en le même matériau et sont d'un seul tenant, formant une pièce complexe unique : malgré sa forme complexe, cette pièce unique reste cependant réalisable par mise en oeuvre de techniques classiques de moulage, notamment lorsqu'elle est constituée en caoutchouc siliconé. Cette structure monobloc procure une meilleure étanchéité en supprimant des raccords de pièces souvent générateurs de fuites indésirables. En outre, on obtient, là aussi, une réduction très intéressante du nombre des pièces composantes de la structure du fait que le soufflet est apte à jouer le double rôle de conduit étanche de longueur variable et de ressort appliquant élastiquement la cloche contre le support de l'élément dont on souhaite régler la température.

Si l'on souhaite en outre prévenir les inconvénients résultant d'une mauvaise étanchéité de l'appui de la cloche sur le support avec lequel elle est amenée à coopérer, il est possible de prévoir que la paroi latérale de la cloche est doublée extérieurement par une jupe mince située à distance de celle-ci en définissant une chambre périphérique et qu'un tube d'amenée d'un gaz sec débouche dans cette chambre périphérique.

L'invention sera mieux comprise à la lecture de la description détaillée qui suit d'un mode de réalisation préféré, donné uniquement à titre d'exemple non limitatif, et dans laquelle on se réfère au dessin annexé sur lequel la fig 2 est une vue schématique, en coupe transversale, d'un dispositif de réglage thermique agencé conformément à l'invention (les éléments identiques à ceux de la fig. 1 y sont désignés par les mêmes références numériques).

De même que le dispositif de l'art antérieur représenté à la fig 1, le dispositif de l'invention comprend un corps 1 (simplement suggéré sur le dessin et dont l'équipement intérieur n'est pas montré) qui est traversé par un conduit 2 d'amenée de gaz à la température souhaitée, dont l'extrémité inférieure 3 supporte à coulissement un manchon extérieur 4. Sur celui-ci est sertie une cloche 6 dimensionnée et configurée pour pouvoir coiffer un composant électronique 7 monté (mécaniquement et électriquement) sur un support 8.

Un soufflet tubulaire 15, sensiblement coaxial au conduit 2, est interposé de façon étanche entre la cloche 6 et le fond isolant 16 du corps 1 ; des passages 17 sont prévus dans la paroi de fond de la cloche pour faire communiquer le volume intérieur de la cloche et la chambre annulaire A délimitée par le soufflet 15. De façon avantageuse, le soufflet 15 est réalisé dans le même matériau que la cloche 6 et est constitué d'une seule pièce avec celle-ci, par exemple par moulage. On évite ainsi la réalisation d'un joint de liaison étanche entre le soufflet et la cloche et l'on écarte une cause possible de fuite en cours d'utilisation.

Le matériau constitutif de la cloche 6 et du soufflet 15 est un très bon isolant thermique de manière que leurs surfaces externes respectives,qui sont en contact avec l'atmosphère ambiante, soient thermiquement isolées de l'atmosphère interne : lors d'essais sous très basses températures (par exemple -60°C), on est ainsi assuré qu'il ne se produira pas de formation de condensation de la vapeur d'eau ni de givrage de celle-ci. Avantageusement, ce matériau est du caoutchouc siliconé.

Enfin, et il s agit là aussi d'une simplification structurelle importante, la conformation géométrique du soufflet et la nature de son matériau constitutif peuvent être déterminés de manière telle que le soufflet soit à même de jouer le rôle du ressort 5 du dispositif de l'art antérieur et qu'il soit à même de repousser élastiquement la cloche 6 vers le bas pour la maintenir en appui élastique étanche contre la surface du support 8.

En outre, pour simplifier la structure et la fabrication du soufflet 15, l'épaisseur de sa paroi est relativement peu importante ; cette faible épaisseur étant impropre à assurer l'isolement thermique recherché, on fait en sorte qu'en cours d'utilisation le soufflet soit complètement écrasé sur lui-même, à spires jointives, ce qui offre l'intérêt de procurer une épaisseur effective d'utilisation beaucoup plus considérable, d'où l'obtention d une bonne isolation thermique comme recherché (sur la fig. 2, le soufflet 15 n'a pas été représenté écrasé sur lui-même pour que le dessin demeure plus aisément lisible).

Il résulte de ce qui précède que la structure de la tête de réglage thermique conforme à l'invention présente une simplification considérable par rapport à la structure antérieurement connue puisque la fonction d'isolement de l'élément 7 vis-à-vis de l'atmosphère ambiante est désormais assurée par une seule et unique pièce facile à mettre en place et peu fragile.

Le fond 16 du corps est percé d'un passage 18 s'ouvrant dans la chambre annulaire A et auquel est raccordé un tube d'évacuation 19 qui est situé à l'intérieur du corps 1 et qui s'étend sur toute la hauteur de celui-ci. Les gaz sont donc rejetés vers le haut, loin de la cloche 6.

Si le bord inférieur de la cloche 6 ne s'adapte pas de façon parfaitement étanche contre la surface du support 8 du composant 7 (cas d'une cloche de section rectangulaire par exemple, dont les faces sont déformées sous l'effet de la surpression interne), il en résulte des fuites pouvant provoquer une condensation de l'humidité de l'atmosphère ambiante avec un risque de givrage dans le cas de basses températures. Il est possible de remédier à cet inconvénient en provoquant un passage de gaz sec, notamment d'air sec, à la base de la cloche. A cet effet, il est possible d'adjoindre à la cloche 6 une jupe périphérique externe 20 à paroi mince et relativement souple, pour délimiter avec celle-ci une chambre périphérique 21. La largeur de cette chambre périphérique 21 est décroissante du haut vers le bas (par exemple le bas de la jupe 20 est rabattu vers la paroi latérale de la cloche) de manière à constituer un Venturi périphérique qui accélère l'écoulement d'air sec au droit des fuites possibles, en empêchant ainsi la formation de givre en ces emplacements. L'air sec est amené dans la chambre 21 par un tube 22 qui est renfermé à l'intérieur du corps 1 de la tête de la même manière que le tube d'évacuation 19 et qui, après avoir traversé la chambre annulaire A, débouche dans la partie haute de la chambre périphérique 21.

Comme il va de soi et comme il résulte d'ailleurs déjà de ce qui précède, l'invention ne se limite nullement à ceux de ses modes d'application et de réalisation qui ont été plus particulièrement envisagés ; elle en embrasse, au contraire, toutes les variantes.

## Revendications

1. Dispositif de réglage thermique pour ajuster à une valeur souhaitée positive ou négative la température d'un élément, notamment d'un composant semi-conducteur en cours de test électrique dans des conditions thermiques variables, cet ajustement de température étant obtenu par soufflage, sur l'élément, d'un gaz à la température souhaitée, ce dispositif de règlage thermique comportant un corps (1) supportant un conduit (2) d'amenée du gaz à la température appropriée et des moyens d'isolement de l'élément vis-à-vis de l'atmosphère ambiante, ces moyens d'isolement comprenant une cloche d'isolement (6) agencée pour coiffer l'élément (7) et supportée à coulissement par l'extrémité libre du conduit précité, des moyens élastiques étant interposés entre la cloche d'isolement et le corps du dispositif pour maintenir cette cloche en appui élastique étanche contre le support (8) de l'élément avec lequel elle coopère, caractérisé par la combinaison des dispositions qui suivent :

- entre la cloche d'isolement (6) et le corps (1) est interposé un soufflet tubulaire (15) sensiblement coaxial au conduit d'amenée de gaz et définissant, avec les parois en regard de la cloche d'isolement, du corps et du conduit, une chambre annulaire (A), ledit soufflet étant en outre agencé pour jouer le rôle des susdits moyens élastiques maintenant la cloche en appui élastique étanche contre le support de l'élément ;
- la cloche (6) et le soufflet (15) sont tous deux constitués en un matériau ou en des matériaux respectifs très bons isolants thermiques ;
- la cloche (6) est munie d'au moins un passage (17) établissant une communication entre son volume intérieur et ladite chambre annulaire ;
- le corps (1) du dispositif est traversé sur toute sa hauteur par un tube d'évacuation (19) s'ouvrant dans la chambre annulaire à son extrémité inférieure (en 18) et débouchant dans l'atmosphère à son extrémité supérieure.

2. Dispositif de réglage thermique selon la revendication 1, caractérisé en ce que le soufflet (15) possède une paroi relativement peu épaisse et en ce qu'en position de fonctionnement le soufflet est écrasé sur lui-même, à spires jointives constituant une paroi effective épaisse et isolante.

3. Dispositif de réglage thermique selon la revendication 1 ou 2, caractérisée en ce que la cloche d'isolement (6) et le soufflet (15) sont constitués en le même matériau et sont d'un seul tenant, formant une pièce complexe unique.

4. Dispositif de réglage thermique selon la revendication 3, caractérisée en ce que la pièce unique regroupant la cloche d'isolement et le soufflet est une pièce moulée en caoutchouc siliconé.

5. Dispositif de réglage thermique selon l'une quelconque des revendications 1 à 4, caractérisée en ce que la paroi latérale de la cloche (6) est doublée extérieurement par une jupe mince (20) située à distance de celle-ci en définissant une chambre périphérique (21) et en ce qu'un tube (22) d'amenée d'un gaz sec débouche dans cette chambre périphérique (21).

FIG.1.

FIG.2.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN, vol. 7, no. 21 (E-155)[1166], 27 janvier 1983; & JP-A-57 178 351 (NIPPON DENSHIN DENWA KOSHA) 02-11-1982 <br> --- | 1 | H 01 L   23/46 <br> H 01 L   21/00 <br> G 01 R   31/28 |
| A | IBM TECHNICAL DISCLOSURE BULLETIN, vol. 12, no. 3, août 1969, page 379, New York, US; R.C. CHU et al.: "Integrated cooling and contacting arrangement" <br> * En entier * <br> --- | 1 | |
| A | FR-A-2 227 537  (LABORATOIRE CENTRAL DES INDUSTRIES ELECTRIQUES) <br> * Page 3, ligne 14 - page 4, ligne 6; figure 2 * <br> --- | 1 | |
| A | EP-A-0 217 676  (FUJITSU LTD) <br> * Colonne 1, lignes 13-38; colonne 4, lignes 56-65; figures 24,27,30 * <br> ----- | 1,3-4 | |

**DOMAINES TECHNIQUES RECHERCHES (Int. Cl.4)**

G 01 R   31/00
H 01 L   21/00
H 01 L   23/00
H 05 K   13/00
F 27 B    5/00
F 27 B   17/00

Le présent rapport a été établi pour toutes les revendications

| Lieu de la recherche | Date d'achèvement de la recherche | Examinateur |
|---|---|---|
| LA HAYE | 05-09-1989 | TRELEVEN C. |

EPO FORM 1503 03.82 (P0402)